# EUROPÄISCHE PATENTSCHRIFT

(11) **EP 1 584 931 B1**
(45) Veröffentlichungstag und Bekanntmachung des Hinweises auf die Patenterteilung: **07.01.2009**
(21) Anmeldenummer: 05102187.1
(22) Anmeldetag: 18.03.2005
(51) Int. Cl.: G01R 31/12, H02M 7/00, H02B 1/16, G01R 31/02

(54) **Verfahren zum Erkennen eines Isolationsfehlers in einem Hochspannungsumrichter**
Method of detecting an insulation fault in a high voltage converter
Procédé de détection d'un défaut d'isolation dans un convertisseur haute tension

(30) Priorität: 05.04.2004 DE 102004016740
(43) Veröffentlichungstag der Anmeldung: 12.10.2005
(73) Patentinhaber: SIEMENS AKTIENGESELLSCHAFT, 80333 München (DE)
(72) Erfinder: Glinka, Martin, 91080 Spardorf (DE)

(56) Entgegenhaltungen:
- DE-A1- 19 841 133
- GB-A- 531 762
- US-A- 4 477 768
- PATENT ABSTRACTS OF JAPAN Bd. 1997, Nr. 07, 31. Juli 1997 (1997-07-31) & JP 09 084225 A (TOSHIBA CORP), 28. März 1997 (1997-03-28)
- PATENT ABSTRACTS OF JAPAN Bd. 2002, Nr. 02, 2. April 2002 (2002-04-02) & JP 2001 286152 A (TOSHIBA CORP), 12. Oktober 2001 (2001-10-12)

## Beschreibung

Die Erfindung betrifft ein Verfahren zum Erkennen eines Isolationsfehlers in einem Hochspannungsumrichter nach dem Oberbegriff des Anspruchs 1.

Hochspannungsumrichter sind als solche bekannt und werden z.B. in Schienentriebfahrzeugen eingebaut. Geeignete Hochspannungsumrichter sind beispielsweise aus der DE 102 17 889 A1 oder aus der DE 101 03 031 A1 bekannt. Die üblicherweise vorhandene Isolation unterliegt dem Verschleiß. Schon bei einer relativ kleinen Beschädigung der Isolation kann es zu Lichtbögen kommen, da am Umrichter sehr hohe Spannungen anliegen. Lichtbögen führen dann zu einer nicht unerheblichen mechanischen Zerstörung der Isolation. Ein Schaden an der Isolation kann auf die Alterung des Isolationsmaterials zurückzuführen sein. Es ist aber auch eine Zerstörung durch eine Teilentladung im Hochspannungsumrichter möglich. Auch Leckagen im Kühlsystem des Umrichters, die zur Überbrückung der Isolation führen, die Bildung von Kriechströmen durch Verschmutzung, sowie mechanische Einwirkungen auf die Isolation können zu einer Zerstörung, zumindest aber zu einer Beschädigung der Isolation führen.

Aus der US 4 477 768 ist ein Verfahren zum Erkennen eines Isolationsfehlers bekannt, bei dem ein Stromfluss zwischen zwei leitenden Schichten auf einen Fehler in der zwischen diesen leitenden Schichten angeordneten Isolatorschicht hinweist.

Bisher war es üblich, zur Stabilisierung der Isolation diese für Spannungswerte auszulegen, die weit höher sind als die am Hochspannungsumrichter vorkommenden Spannungswerte. Dadurch ergab sich für den isolierten Hochspannungsumrichter ein sehr hohes Gewicht und auch ein sehr großes Volumen, da zur Vermeidung von Kriechströmen sehr große freie Räume, sogenannte Luftstrecken, vorgesehen waren.

Der Erfindung liegt die Aufgabe zugrunde, ein Verfahren anzugeben, mit dem Isolationsfehler in einem Hochspannungsumrichter frühzeitig und zuverlässig zu erkennen sind, so dass vor einem zu großen Schaden Maßnahmen ergriffen werden können.

Die Aufgabe, ein geeignetes Verfahren zum Erkennen eines Isolationsfehlers in einem Hochspannungsumrichter anzugeben, wird gemäß der Erfindung durch die Merkmalskombination des Anspruchs 1 gelöst.

Bei diesem Verfahren wird die elektrisch leitende Hülle durch die beiden angrenzenden Isolationshüllen geschützt, so dass sich das Potential der leitenden Hülle nicht verändern kann. Erst bei einer Beschädigung von zumindest einer der beiden Isolationshüllen kommt die leitende Hülle mit einem anderen Potential in Verbindung, so dass ein detektierbarer Strom fließt.

Es kann also vorteilhaft eine Beschädigung an einer der beiden Isolationshüllen erkannt und auch behoben werden, solange die andere Isolationshülle noch einen ausreichenden Isolationsschutz bietet.

Vorteilhafte Ausgestaltungen sind den Unteransprüchen zu entnehmen.

Beispielsweise wird bei einem Stromfluss zur Potentialquelle hin ein Isolationsfehler an der ersten, inneren Isolationshülle angezeigt. Das ist darauf zurückzuführen, dass dann das hohe Potential des Hochspannungsumrichters, insbesondere von dessen Submodulen aus, auf die elektrisch leitende Hülle gelangt.

Bei einem Stromfluss von der Potentialquelle weg wird beispielsweise ein Isolationsfehler an der zweiten, äußeren Isolationshülle angezeigt. Dann erfolgt nämlich ein Stromfluss von der elektrisch leitenden Hülle zum geerdeten Gehäuse des Hochspannungsumrichters.

Es ist also am Vorzeichen der Potentialänderung zu erkennen, welche Isolationshülle beschädigt ist.

Der Stromfluss wird beispielsweise an einem Widerstand gemessen, der sich zwischen der elektrisch leitenden Hülle und der Potentialquelle befindet. Auf diese Weise ist eine besonders zuverlässige Messung möglich.

Beispielsweise ist mindestens ein Submodul mit separater erster Isolationshülle vorhanden. Aus einer Messung des Differenzstromes zwischen Anschlussklemmen des Submoduls wird dann auf einen Isolationsfehler an der separaten Insolationshülle geschlossen.

Beispielsweise wird der Differenzstrom unter Berücksichtigung von Betriebsdaten des Hochspannungsumrichters gefiltert. Das wird z.B. in einer Auswerteeinheit ausgeführt.

Es wird der Vorteil erzielt, dass durch eine zusätzliche Messung an den Anschlussklemmen des Submoduls/der Submodule nicht nur zwischen einer Beschädigung der inneren, ersten, und der äußeren, zweiten, Isolationshülle unterschieden werden kann, sondern dass sogar detektiert werden kann, an welchem Submodul ein Isolationsschaden vorliegt.

Ein Schaden an einer Isolationshülle, aber auch ein gleichzeitiger Schaden an beiden Isolationshüllen, kann schnell und zuverlässig erkannt werden, so dass eine Reparatur oder ein Austausch der Isolationshüllen möglich ist, bevor große Folgeschäden auftreten können. Wenn kein Schaden vorliegt, ist das an der elektrisch leitenden Hülle anliegende Potential ungleich Null. Ein geeignetes Potential liegt zwischen 100V und einigen kV.

Da sich außerhalb der zweiten Isolationshülle noch ein geerdetes Gehäuse befindet, verschiebt sich das Potential der elektrisch leitenden Hülle bei einer Beschädigung der inneren, ersten Isolationshülle in Richtung auf das Hochspannungspotential des Hochspannungsumrichters und bei einer Beschädigung der zweiten oder äußeren Isolationshülle in Richtung auf das Nullpotential des Gehäuses. Es kann also nicht nur eine Beschädigung der Isolation festgestellt werden, sondern auch ein Hinweis darauf gegeben werden, welche der beiden Isolationshüllen beschädigt ist.

Beispielsweise steht die Potentialquelle über einen elektrischen Widerstand mit der elektrisch leitenden Hülle in Verbindung.

Es kann mindestens ein Submodul vorhanden sein, wobei zum Erkennen eines Isolationsfehlers mit Anschlussklemmen des Submoduls ein Stromstärkemesser verbunden ist..

Eine Änderung des Stromes an nur einem Submodul kann bei gleichzeitiger Änderung des Potentials an der elektrisch leitenden Hülle ein Indiz dafür sein, dass, falls separate Isolationen für die Submodule vorhanden sind, die Isolation desjenigen Submoduls beschädigt ist, an dem der geänderte Stromstärkewert aufgetreten ist. Es kann also der Fehlerort hinsichtlich der Submodule besonders gut festgelegt werden.

Mit dem Verfahren zum Erkennen eines Isolationsfehlers nach der Erfindung wird insbesondere der Vorteil erzielt, dass eine Zerstörung des Hochspannungsumrichters durch einen Isolationsfehler weitgehend ausgeschlossen ist und darüber hinaus das Restrisiko einer Zerstörung durch eine frühzeitige Fehlererkennung und durch geeignete Gegenmaßnahmen, z.B. Austausch oder Reparatur, minimiert ist.

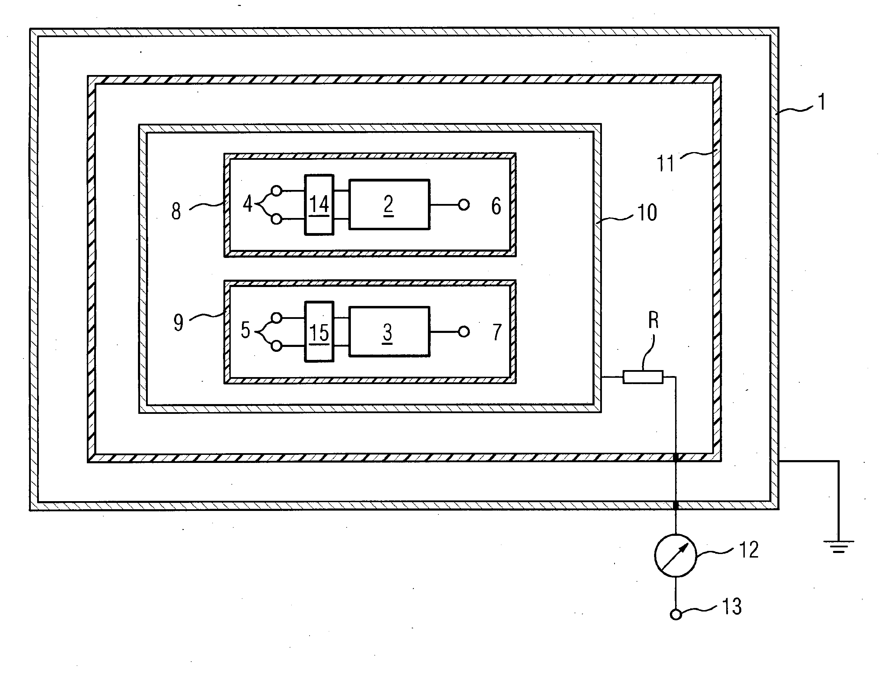

Das Verfahren zum Erkennen eines Isolationsfehlers wird beispielhaft anhand eines in der Zeichnung dargestellten Hochspannungsumrichters näher erläutert:

In einem geerdeten Gehäuse 1 eines Hochspannungsumrichters befinden sich mehrere Submodule 2 und 3, von denen zwei dargestellt sind. Beide Submodule 2 und 3 weisen Anschlussklemmen 4 und 5 und als Datenleitungsanschlüsse Lichtwellenleiteranschlüsse 6 und 7 auf. Daran können z.B. Lichtwellenleiter angeschlossen sein, die zur zentralen Steuereinheit des Hochspannungsumrichters führen. Es kann sich dabei um Potential trennende Datenleitungen handeln. Jedes Submodul 2, 3 ist von einer ersten, inneren Isolationshülle 8, 9 umschlossen. Um die ersten Isolationshüllen 8 und 9 zusammen erstreckt sich eine elektrisch leitende Hülle 10. Diese ist wiederum von einer zweiten, äußeren Isolationshülle 11 umgeben. Außerhalb dieser zweiten Isolationshülle 11 befindet sich das geerdete Gehäuse 1. Die elektrisch leitende Hülle 10 ist über einen Widerstand R und einen Stromstärkemesser 12 an eine Potentialquelle 13 angeschlossen, deren Potential zwischen einigen 100 V und wenigen Kilovolt liegt.

Bei einem Schaden an einer oder an beiden ersten, inneren Isolationshüllen 8, 9, die die Submodule 2, 3, an denen ein hohes Potential anliegt, umschließen, steigt das Potential an der elektrisch leitenden Hülle 10 an und führt zu einem Stromfluss zur Potentialquelle 13 hin.

Ein Schaden an der zweiten, äußeren Isolationshülle 11 führt zu einem Stromfluss von der elektrisch leitenden Hülle 10 über das Gehäuse 1 zur Erde und damit zu einem Stromfluss, der von der Potentialquelle 13 ausgeht.

Zusätzliche Stromstärkemesser 14, 15 an den Anschlussklemmen 4, 5 der Submodule 2, 3 zeigen an, ob die jeweilige erste, innere Isolationshülle 8, 9 des Submoduls 2, 3 defekt ist. Vernachlässigt man Umladeströme über parasitäre Kapazitäten zwischen den Submodulen 2 und 3 und ihrer Umgebung, dann ist der Betrag des Differenzstromes der Strömstärkemesser 14, 15 praktisch Null. Das gilt solange, wie die ersten Isolationshüllen 8 und 9 nicht beschädigt sind. Bei einem Isolationsschaden an einer der ersten Isolationshüllen 8, 9 ist der Differenzstrom nicht mehr Null. Auf diese Weise kann mit den Stromstärkemessern 14, 15 ein Isolationsfehler detektiert werden.

Aufgrund der genannten parasitären Kapazitäten kann die Messung des Differenzstromes gestört sein. Für kurze Zeit fließende Ströme sind dann nicht auf Isolationsfehler, sondern auf die parasitären Kapazitäten zurückzuführen. Solche Ströme können während der Schaltvorgänge von Leistungshalbleiterschaltern in den Submodulen 2, 3 auftreten.

Die zentrale Steuereinheit des Hochspannungsumrichters ist jedoch in der Lage, diese betriebsbedingten Ströme von eventuellen Isolationsfehlerströmen zu unterscheiden, da in der zentralen Steuereinheit genau bekannt ist, wann die einzelnen Submodule 2, 3 aufgrund der Steuerung des Umrichters einen Potentialsprung haben. Damit wird der Vorteil erzielt, dass Ströme, die beispielsweise durch Schalthandlungen ausgelöst werden, aus den Messsignalen der Stromstärkemesser 14 und 15 herausgefiltert werden können. Dazu wird die gemessene Stromstärke der Stromstärkemesser 14 und 15 z.B. für die Zeitspanne, in der im Hochspannungsumrichter Leistungshalbleiter schalten, ausgeblendet.

Hierzu eignet sich in besonderer Weise die zentrale Steuereinheit des Hochspannungsumrichters, da sie über fast alle Betriebsinformationen des Hochspannungsumrichters verfügt. Es wird der Vorteil erzielt, dass die benötigten Informationen nicht jedem Submodul einzeln zugeleitet werden müssen.

Zur Verarbeitung der Messsignale der Stromstärkemesser 14 und 15 werden diese Messsignale über eine optische, Potential trennende Schnittstelle zur zentralen Steuereinheit übertragen. Beispielsweise werden die Stromstärkewerte als digitalisierte Analogwerte weitergeleitet. Es kann in einfacher Weise festgestellt werden, ob die Stromstärkewerte einen zuvor festgelegten Grenzwert überschritten haben.

Es wird der Vorteil erzielt, dass nicht nur erkannt werden kann, ob die ersten Isolationshüllen 8, 9 oder die zweite Isolationshülle 11 beschädigt sind, sondern es kann durch gleichzeitige Stromstärkemessungen an den Anschlussklemmen 4, 5 der Submodule 2, 3 sofort erkannt werden, an welchem Submodul 2, 3 die Isolationshülle 8, 9 beschädigt ist.

Es wird der Vorteil erzielt, dass für einen Hochspannungsumrichter mit hoher Zuverlässigkeit eine leichte und platzsparende Bauweise ausreicht und dass ein Fehler, der noch nicht zu einer Beeinträchtigung der Arbeit des Hochspannungsumrichters führt, frühzeitig erkannt und behoben werden kann.

## Patentansprüche

1. Verfahren zum Erkennen eines Isolationsfehlers in einem Hochspannungsumrichter mit einer elektrisch leitenden Hülle (10), die zwischen einer ersten (8, 9) und einer zweiten Isolationshülle (11) angeordnet und mit einer Potentialquelle (13), an der ein Potential anliegt, und einem Stromstärkemesser (12) verbunden ist, **dadurch gekennzeichnet, dass** die zweite Isolationshülle (11) von einem geerdeten Gehäuse (1) umgeben ist, dass bei einem Stromfluss von der elektrisch leitenden Hülle (10) zur Potentialquelle (13) hin ein Isolationsfehler an der ersten Isolationshülle (8, 9) angezeigt wird und dass bei einem Stromfluss von der Potentialquelle (13) weg ein Isolationsfehler an der zweiten Isolationshülle (11) angezeigt wird.

2. Verfahren nach Anspruch 1, **dadurch gekennzeichnet, dass,** wenn mindestens ein Submodul (2, 3) mit separater erster Isolationshülle (8, 9) vorhanden ist, aus einer Messung des Differenzstromes zwischen Anschlussklemmen (4, 5) des Submoduls (2, 3) auf einen Isolationsfehler an der separaten Isolationshülle (8, 9) geschlossen wird.

3. Verfahren nach Anspruch 2, **dadurch gekennzeichnet, dass** der Differenzstrom unter Berücksichtigung von Betriebsdaten des Hochspannungsumrichters gefiltert wird.

## Claims

1. Method of detecting an insulation fault in a high-voltage converter with an electrically conductive jacket (10), which is arranged between a first (8, 9) and a second insulation jacket (11) and is connected to a potential source (13), at which a potential is applied, and to a current level meter (12), **characterized in that** the second insulation jacket (11) is surrounded by an earthed housing (1), **in that**, in the event of a current flow from the electrically conductive jacket (10) towards the potential source (13), an insulation fault at the first insulation jacket (8, 9) is indicated, and **in that**, in the case of a current flow away from the potential source (13), an insulation fault at the second insulation jacket (11) is indicated.

2. Method according to Claim 1, **characterized in that** if at least one submodule (2, 3) with a separate first insulation jacket (8, 9) is provided, an insulation fault at the separate insulation jacket (8, 9) is concluded from a measurement of the differential current between the connection terminals (4, 5) of the submodule (2, 3).

3. Method according to Claim 2, **characterized in that** the differential current is filtered taking into consideration operational data of the high-voltage converter.

## Revendications

1. Procédé de détection d'un défaut d'isolation dans un convertisseur de haute tension qui comprend une enveloppe ( 10 ) conductrice d'électricité, et disposée entre une première ( 8, 9 ) et une deuxième ( 11 ) enveloppe isolante, et qui est relié à une source ( 13 ) de potentiel, à laquelle s'applique un potentiel, et à un ampèremètre ( 12 ), **caractérisé en ce que** la deuxième enveloppe ( 11 ) isolante est entourée d'un boîtier ( 1 ) mis à la terre, **en ce que**, lors d'un flux de courant allant de l'enveloppe ( 10 ) conductrice d'électricité à la source ( 13 ) de potentiel, un défaut d'isolation sur la première enveloppe ( 8, 9 ) isolante est indiqué et **en ce que**, pour un flux de courant s'éloignant de la source ( 13 ) de potentiel un défaut d'isolation sur la deuxième enveloppe isolante est indiqué.

2. Procédé selon la revendication 1, **caractérisé en ce que,** lorsqu'il y a au moins un sous module ( 2, 3 ) ayant une première enveloppe ( 8, 9 ) isolante distincte, on déduit d'une mesure du courant de différence entre des bornes ( 4, 5 ) du sous-module ( 2, 3 ) un défaut d'isolation sur l'enveloppe ( 8, 9 ) isolante distincte.

3. Procédé selon la revendication 2, **caractérisé en ce que** le courant de différence est filtré en tenant compte de données de fonctionnement du convertisseur de haute tension.
